# EUROPÄISCHE PATENTSCHRIFT

(11) **EP 3 213 061 B1**
(45) Veröffentlichungstag und Bekanntmachung des Hinweises auf die Patenterteilung: **08.12.2021**
(21) Anmeldenummer: 15797578.0
(22) Anmeldetag: 19.10.2015
(51) Int. Cl.: G01N 27/416, G01N 17/00, G01N 17/02

(54) **VERFAHREN ZUR ELEKTROCHEMISCHEN QUALITÄTSKONTROLLE ELEKTRISCH LEITENDER GEGENSTÄNDE**
METHOD FOR ELECTROCHEMICAL QUALITY MONITORING OF ELECTRICALLY CONDUCTING MATERIALS
PROCEDE DE CONTROLE ELECTROCHIMIQUE DE LA QUALITE D'OBJETS CONDUCTEURS D'ELECTRICITE

(30) Priorität: 27.10.2014 AT 7862014
(43) Veröffentlichungstag der Anmeldung: 06.09.2017
(73) Patentinhaber: MTI GmbH, 9500 Villach (AT)
(72) Erfinder: HACKSTEINER, Markus, 9500 Villach (AT)
(74) Vertreter: Beer & Partner Patentanwälte KG
(86) Internationale Anmeldenummer: PCT/AT2015/000133
(87) Internationale Veröffentlichungsnummer: WO 2016/065379

(56) Entgegenhaltungen:
- DE-A1- 3 715 881
- US-A- 4 575 678
- US-A- 6 026 691
- US-A1- 2004 016 648
- US-A1- 2005 109 624
- US-A1- 2008 223 724
- POELMAN M ET AL: "Electrochemical study of different ageing tests for the evaluation of a cataphoretic epoxy primer on aluminium", PROGRESS IN ORGANIC COATINGS, ELSEVIER BV, NL, Bd. 54, Nr. 1, 1. September 2005 (2005-09-01), Seiten 55-62, XP027868944, ISSN: 0300-9440 [gefunden am 2005-09-01]
- ALEKSANDER JAWORSKI ET AL: "Copper ECD Process Control by Means of Electroanalysis Combined with Multi-way Data Decomposition Chemometric Techniques", ECS TRANSACTIONS, Bd. 6, 1. Januar 2008 (2008-01-01), Seiten 39-52, XP055242929, DOI: 10.1149/1.2831728
- Jean-Luc Baltzinger ET AL: "Contamination monitoring and analysis in semiconductor manufacturing 57 x Contamination monitoring and analysis in semiconductor manufacturing" In: "Contamination Monitoring and Analysis in Semiconductor Manufacturing, Semiconductor Technologies", 1. Januar 2010 (2010-01-01), InTech, XP055242597, ISBN: 978-953-30-7080-3 das ganze Dokument
- "Flat Cell For the Electrochemical Study of Corrosion and Coatings/Films", , 1. April 2014 (2014-04-01), XP055242755, Gefunden im Internet: URL:https://www.pineinst.com/echem/files/d ocs/drp10055_flat_cell_product_guide.pdf [gefunden am 2016-01-19]
- None

## Beschreibung

Die Erfindung betrifft ein Verfahren zum Prüfen elektrisch leitender Gegenstände.

Aus der US 5,820,746 A ist es bekannt, einen (Halbleiter-)Wafer, der auf seiner Oberfläche Metall enthält, mit Ionen, die das Metall korrodieren, in Berührung zu bringen, wobei eine Konstantstromelektrolyse in einem Galvanostaten angewendet wird. Das Elektrodenpotential des Metalls wird gemessen. Auf diese Weise soll einerseits die Beziehung zwischen Stromwert und Zeit bis zum Lochfraß und anderseits ein kritischer Stromwert ermittelt werden, auf Grund dessen das Metall hinsichtlich Oberflächenglattheit, Korrosionswiderstand der Metalloberfläche, Widerstand gegen Lochkorrosion, Segregationswert und Konzentration von Spurenelementen im Metall und Korngröße oder Kornabmessung im Metall beurteilt wird.

Aus der US 2010/0200431 A1 ist ein Verfahren zum Prüfen von Wafern bekannt. Dabei wird Elektrolyt auf die Metall enthaltende Fläche des Wafers aufgebracht. Mit Hilfe von Elektroden, die einerseits mit einem anderen nicht von Elektrolyt bedeckten Bereich der Metall enthaltenden Fläche und anderseits mit der von Elektrolyt bedeckten Fläche in Kontakt stehen, wird der elektrische Widerstand gemessen. So sollen die Menge von Rückständen und das Ausmaß von Korrosion in einer Seitenwand der Metall enthaltenden Fläche des Wafers bestimmt werden.

Die JP H07111286 A befasst sich mit dem Beurteilen von Oberflächen dünner Filme, wobei ein Elektrolyt aufgebracht wird und zwischen einer Referenz-Elektrode, die in den Elektrolyt eintaucht, und einer weiteren Elektrode, die am Substrat anliegt, Strom angelegt wird. Die sich ergebende Spannung zwischen den im Substrat eingebetteten Drain- und Source-Bereichen soll gemessen werden, um Verunreinigungen zu erfassen.

Aus der US 5110537 A ist ein Verfahren und eine Apparatur zum Bestimmen der Wasserqualität bekannt. Dabei sollen Änderungen der Qualität von Wasser durch das Erfassen von Änderungen der Korrosionsgeschwindigkeit erfasst werden, wobei korrosionsbedingte Änderungen der Kapazität zwischen den Elektroden ermittelt werden.

Der Erfindung liegt die Aufgabe zugrunde, ein Verfahren der eingangs genannten Gattung anzugeben, mit der eine laufende Qualitätskontrolle elektrischer Erzeugnisse (elektrisch leitender Gegenstände), wie Wafer, Mikrochips u.dgl., und eine Prozessentwicklung möglich sind.

Gelöst wird diese Aufgabe erfindungsgemäß mit einem Verfahren bei dem die Schritte von Anspruch 1 ausgeführt werden.

Bevorzugte und vorteilhafte Ausgestaltungen des erfindungsgemäßen Verfahrens sind Gegenstand der abhängigen Unteransprüche.

Ein großer Vorteil des erfindungsgemäßen Verfahrens gegenüber optischen Messmethoden (z.B. Röntgengeräte) liegt darin, dass Interaktions-Reaktionen zwischen einerseits Einzelprozessergebnis und anderseits Einzelprozessmedium charakterisiert werden können.

Interaktions-Reaktion: das können Oxidationen sein, die sich z.B. durch Korrosionserscheinungen oder Leckströme äußern. Das können weiters Reduktionen sein, die sich z.B. durch Wasserstoffbildung äußern. Das können auch chemische Reaktionen sein.

Einzelprozessergebnis: z.B. Metallschicht oder Schutznitridschicht; generell: elektrisch leitfähige Schicht bzw. Schichtsandwich bzw. konditionierte/gereinigte Waferoberfläche.

Einzelprozessmedium: z.B. Ätzflüssigkeit oder Reinigungsflüssigkeit; generell: elektrisch leitfähige Flüssigkeit, diese wird als Messflüssigkeit verwendet.

Unter dem Begriff "elektrische Eigenschaften" werden im Vorliegenden sowohl elektrische Eigenschaften, wie Widerstand, Kapazität u.s.w., als auch elektrochemische Eigenschaften (beispielsweise Korrosion durch Lokalelementbildung bei kontaminierten Metallschichten bei Vorhandensein einer Flüssigkeit/Feuchte bzw. Messflüssigkeit) verstanden.

Bei der Erfindung werden elektrische Eigenschaften von Gegenständen, beispielsweise durch das Messen von Strom-Spannungs-Kurven, Strom-Zeit-Kurven, Spannungs-Zeit-Kurven (z.B. Open Circuit Potential-Messung), Impedanzen (allgemeine elektrochemische Methoden), erfasst und Merkmale elektrischer Eigenschaften, beispielsweise der Kurven, wie beispielsweise deren Steigung an einem bestimmten Punkt, welche die Qualität einer Kathodenoberfläche (z.B. einer Waferoberfläche), einer Kathodenschicht oder eines Kathodeninterfaces charakterisieren, gespeichert. Als elektrische Eigenschaften können auch Widerstände und/oder Kapazitäten erfasst werden. Da diese Qualitätskontrolle, also das Messen von Strom-Spannungs-Kurven, Strom-Zeit-Kurven, Spannungs-Zeit-Kurven, Impedanzen, usw. periodisch, z.B. einmal in der Woche, ausgeführt wird, kann durch einen Vergleich von Merkmalen elektrischer Eigenschaften durch statistische Auswertung eine Veränderung der Oberflächen- bzw. Schichtqualität (sofort) erkannt werden. Damit ist es möglich, Produktionsausfälle zu vermeiden, da die Produktionsstabilität überwacht wird.

Das erfindungsgemäße Verfahren kann auch im Rahmen von Einzelprozess-Neuentwicklungen und Einzelprozess-Optimierungen hilfreich sein. Hier können sowohl die Originalelektrolyte aus den Produktionsprozessen als auch frei wählbare Elektrolyte eingesetzt werden. Neben der hohen Messempfindlichkeit der Vorrichtung und des Verfahrens ergibt sich im Falle des Einsatzes von Originalelektrolyten der zusätzliche Vorteil, für Untersuchungen die Produktionsanlagen nicht immer zu benötigen und damit zu blockieren.

Durch die Anwendung des erfindungsgemäßen Verfahrens ist es auch möglich, Wechselwirkungen eines Werkstückes mit einem Elektrolyten, mit dem es erst zu einem späteren Zeitpunkt der Produktion in Kontakt kommen würde, frühzeitig zu testen.

Daher ist es möglich, dass kritische Wechselwirkungen mit späteren Verfahrensschritten vorab und sofort überprüft werden können.

Insbesondere bei Anlagenfreigaben in der Produktion ist es wichtig, dass diese Beurteilung schnell möglich ist, da die Produktionsanlagen für die Waferfertigung sehr teuer sind.

In einer Ausführungsform des erfindungsgemäßen Verfahrens kann so vorgegangen werden, dass als elektrische Eigenschaften Strom-Spannungs-Kurven, Strom-Zeit-Kurven, Spannungs-Zeit-Kurven und Impedanzen, Widerstände, Kapazitäten, erfasst werden.

In einer Ausführungsform des erfindungsgemäßen Verfahrens kann so vorgegangen werden, dass als Merkmale der Eigenschaften die Steigung des Stromes bei einer definierten Spannung oder der Spannung bei einer definierten Zeit verschiedene Gegenstände miteinander verglichen werden.

In einer Ausführungsform des erfindungsgemäßen Verfahrens kann so vorgegangen werden, dass elektrische Eigenschaften von Gegenständen periodisch und in vorgegebenen Zeitabständen erfasst werden.

Erfindungsgemäß wird ein Vergleich von Merkmalen elektrischer Eigenschaften von nacheinander hergestellten Gegenständen unter Zuhilfenahme statistischer Methode ausgeführt.

In einer Ausführungsform des erfindungsgemäßen Verfahrens kann so vorgegangen werden, dass ein Vergleich der Merkmale elektrischer Eigenschaften eines Gegenstandes mit den Mittelwerten der Merkmale elektrischer Eigenschaften vorher hergestellter Gegenstände ausgeführt wird.

In einer Ausführungsform des erfindungsgemäßen Verfahrens kann so vorgegangen werden, dass die Eigenschaften von elektrisch leitfähigen Schichten, Oberflächen und/oder Grenzflächen (Interfaces) von Gegenständen erfasst werden.

Der Zellendeckel einer zum Ausführen des erfindungsgemäßen Verfahrens verwendbaren Vorrichtung kann einen normal zur Rückseite des Wafers beweglichen Plug enthalten, der durch Gasdruck an die Rückseite des Wafers angepasst wird. Somit drückt die Wafervorderseite auf die Ringsichtung und der Prüfraum ist damit dicht. Das hat den Vorteil, dass verschieden dicke Wafer eingelegt werde können, z.B. gebondete und damit dickere Wafer, und auch den Vorteil, dass die Anpresskraft variiert werden kann (verschieden harte Ringdichtungen).

Bei einer zum Ausführen des erfindungsgemäßen Verfahrens verwendbaren Vorrichtung kann vorgesehen sein, dass die Anode als Anodenplatte ausgebildet ist.

Bei einer zum Ausführen des erfindungsgemäßen Verfahrens verwendbaren Vorrichtung kann vorgesehen sein, dass an Stelle der Anodenplatte eine Platte mit wenigstens zwei chemisch inerten Elektroden, die als Kathode und Referenzelektrode gepolt sind, eingesetzt wird. Die Anodenplatte kann in diesem Fall an Stelle des Gegenstandes eingesetzt werden.

Bei einer zum Ausführen des erfindungsgemäßen Verfahrens verwendbaren Vorrichtung kann vorgesehen sein, dass die Messzellen zwei Deckelteile und einen zwischen diesen angeordneten Mittelteil umfasst, und dass der Prüfraum im Mittelteil vorgesehen ist.

Bei einer zum Ausführen des erfindungsgemäßen Verfahrens verwendbaren Vorrichtung kann vorgesehen sein, dass der Mittelteil von einer oberen Halbzelle und einer unteren Halbzelle gebildet ist.

Bei einer zum Ausführen des erfindungsgemäßen Verfahrens verwendbaren Vorrichtung kann vorgesehen sein, dass die Anodenplatte zwischen einem Anodendeckel und dem Mittelteil, insbesondere der unteren Halbzelle desselben, angeordnet ist.

Bei einer zum Ausführen des erfindungsgemäßen Verfahrens verwendbaren Vorrichtung kann vorgesehen sein, dass auf der dem zu prüfenden Gegenstand zugewendeten Seite des Mittelteils eine Dichtung vorgesehen ist.

Bei einer zum Ausführen des erfindungsgemäßen Verfahrens verwendbaren Vorrichtung kann vorgesehen sein, dass die Dichtung auf dem zu prüfenden Gegenstände, vorzugsweise am Rand oder innerhalb der Fläche des Gegenstandes, aufliegt.

Bei einer zum Ausführen des erfindungsgemäßen Verfahrens verwendbaren Vorrichtung kann vorgesehen sein, dass im Prüfraum eine Öffnung für den Eintritt von Elektrolyt in den Prüfraum vorgesehen ist, und dass für den Austritt von Elektrolyt aus dem Prüfraum eine weitere Öffnung vorgesehen ist.

Bei einer zum Ausführen des erfindungsgemäßen Verfahrens verwendbaren Vorrichtung kann vorgesehen sein, dass die Öffnungen in der unteren Halbzelle vorgesehen sind.

Bei einer zum Ausführen des erfindungsgemäßen Verfahrens verwendbaren Vorrichtung kann vorgesehen sein, dass der Prüfraum durch die Ausnehmungen in den Halbzellen gebildet ist, und durch die Deckelteile abgeschlossen ist.

Bei einer zum Ausführen des erfindungsgemäßen Verfahrens verwendbaren Vorrichtung kann vorgesehen sein, dass ein Deckelteil ein Zellendeckel und der andere Deckelteil ein Anodendeckel ist.

Bei einer zum Ausführen des erfindungsgemäßen Verfahrens verwendbaren Vorrichtung kann vorgesehen sein, dass der Prüfraum zur Horizontalen unter einem spitzen Winkel, insbesondere unter 45°, geneigt ist.

Beispielsweise kann das erfindungsgemäße Verfahren wie folgt angewendet werden:
Beim Abscheiden von Metallschichten kann es zu einer Kontamination der Schicht kommen, wodurch die Schicht unedler (d.h. korrosionsanfälliger) wird. Die Kontamination ist aber mit den üblichen, in der Produktion bisher eingesetzten Apparaturen (Schichtdickenmessgerät, Mikroskop, Schichtwiderstandsmessgerät) nicht erkennbar. Wenn eine kontaminierte Metallschicht zu einem späteren Zeitpunkt der Produktion (beispielsweise zwei Tage später) mit einer Lösung in Berührung kommt, kann die durch die Kontamination unedlere Schicht korrodieren, was zu Produktionsausfällen führt.

Eine langsam (schleichend) einsetzende und zunehmende Kontamination von Metallschichten kann durch elektrochemische Signale, die mit dem erfindungsgemäßen Verfahren erfasst werden können, zeitgerecht erkannt werden.

Somit erlaubt es die Erfindung, rechtzeitig Maßnahmen (z.B. eine Erneuerung des Elektrolyten) zu setzen, noch bevor die Kontamination kritisch wird und zu Produktionsausfällen führt.

Weitere Einzelheiten und Merkmale des erfindungsgemäßen Verfahrens und eine zum Ausführen des erfindungsgemäßen Verfahrens verwendbaren Vorrichtung ergeben sich aus der nachstehenden Beschreibung unter Bezugnahme auf die angeschlossenen Zeichnungen. Es zeigt:
- Fig. 1: in auseinandergezogener Darstellung eine Vorrichtung,
- Fig. 2: eine Vorrichtung im Schnitt quer zur Strömungsrichtung,
- Fig. 3: in Schrägansicht eine untere Halbzelle von oben gesehen,
- Fig. 4: die Halbzelle aus Fig. 3 von unten gesehen,
- Fig. 5: eine Zelle in Darstellung von oben gesehen, ohne Wafer, Ringdichtung, Kontaktierfolie und Zelldeckel und
- Fig. 6: eine Vorrichtung im Schnitt in Strömungsrichtung.

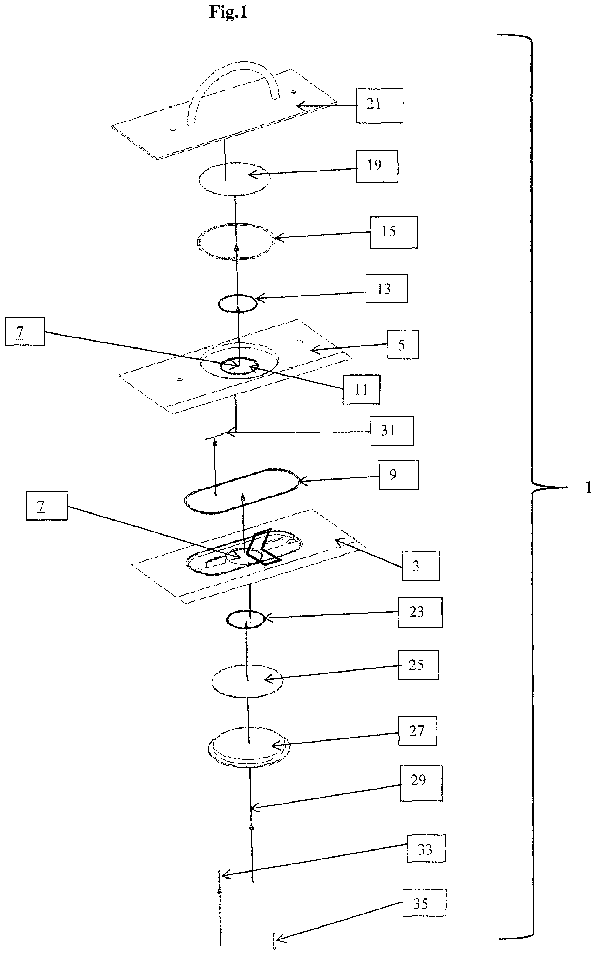

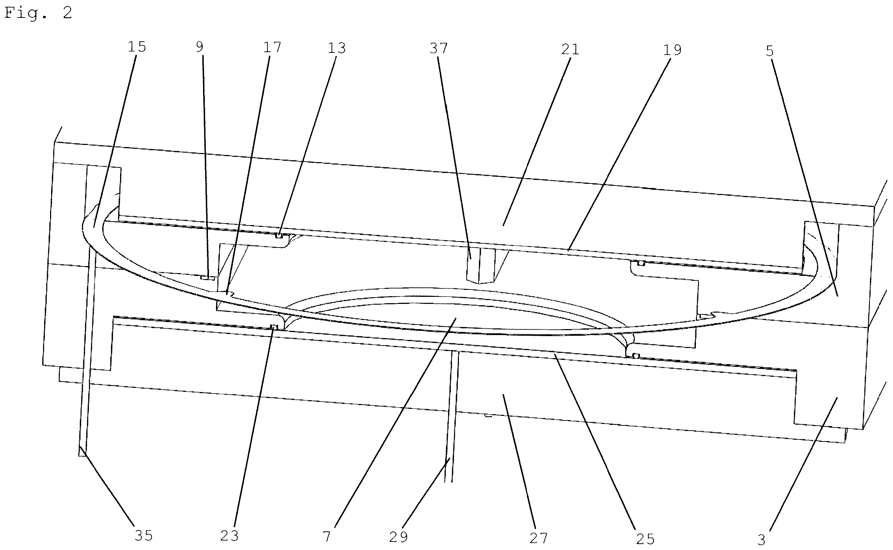

Bei der in den Fig. 1 und 2 gezeigten Ausführungsform umfasst eine als Messzelle ausgebildete Vorrichtung 1 als wesentliche Bauteile eine untere Halbzelle 3 und eine obere Halbzelle 5. Zwischen der unteren Halbzelle 3 und der oberen Halbzelle 5 ist zur Abdichtung eines Prüfraumes 7, der zwischen den Halbzellen 3 und 5 angeordnet ist, eine Flachdichtung 9 angeordnet.

Rings um eine Öffnung 11 in der oberen Halbzelle 5 ist eine Ringdichtung 13 vorgesehen. Außerhalb der Ringdichtung 13 befindet sich eine Folie 15 mit Kontaktpins 17 zum Kontaktieren des Wafers 19. Auf die Kontaktpins 17 wird der zu prüfende Wafer 19 mit seiner Vorderseite nach unten aufgelegt. Schlussendlich wird die Vorrichtung 1 oben durch einen Zellendeckel 21 abgeschlossen.

An der Unterseite der unteren Halbzelle 3 ist eine Ringdichtung 23 vorgesehen, wobei die Ringdichtung 23, beispielsweise in Form eines O-Ringes, zwischen der unteren Halbzelle 3 (Unterseite derselben) und einer Anodenplatte 25 vorgesehen ist. Unterhalb, also außerhalb der Anodenplatte 25, ist ein Anodendeckel 27 vorgesehen. Im Bereich des Anodendeckels 27 ist ein Anodenkontakt 29 vorgesehen. Es können auch zwei oder mehrere Kontakte, z.B. am Rand der Anodenplatte 25, vorgesehen sein.

In einer Aussparung der unteren Halbzelle 3 ist eine Referenzelektrode 31 angeordnet, die, mit Hilfe eines Referenzelektrodenkontaktes 33, elektrisch kontaktiert ist. Der Wafer 19, der mit seiner Vorderseite nach unten, also in Richtung auf die obere Halbzelle 5 hin, ausgerichtet ist, wird über einen Kontakt 35 und die Folie 15 kontaktiert. Der Kontakt 35 ist von unten her bis in Berührung mit der Folie 15 geführt.

Fig. 2 zeigt die Vorrichtung 1 in zusammengebautem Zustand. Fig. 2 zeigt auch, dass der Prüfraum 7 durch (runde) Ausnehmungen in der unteren Halbzelle 3 und in der oberen Halbzelle 5 gebildet wird. Im Prüfraum 7 sind Stege 37 vorgesehen, die zum Leiten der Strömung von Elektrolyt durch den Prüfraum 7 dienen und zusätzlich die Steifheit der Zellgeometrie verbessern.

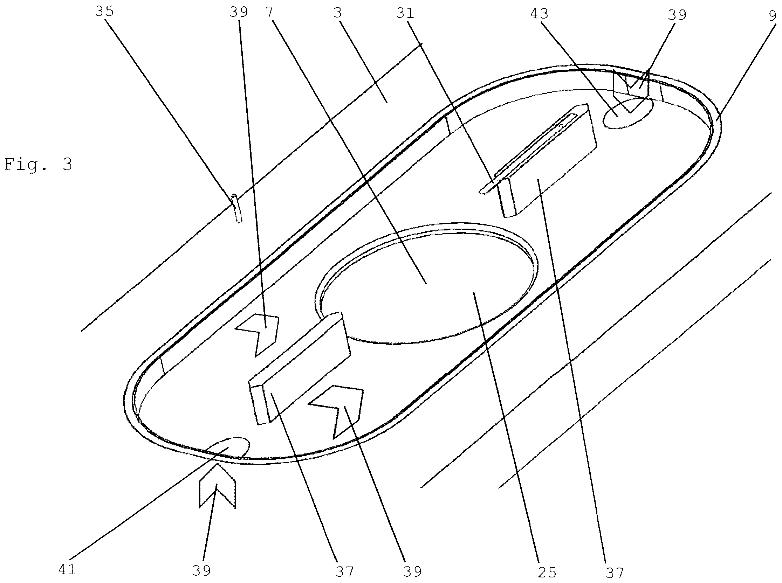

In Fig. 3 ist nochmals gezeigt, wie die Referenzelektrode 31 an der Oberseite der unteren Halbzelle 3 angeordnet ist. Die Referenzelektrode 31 liegt in einer nutartigen Vertiefung des einen Steges 37, der an der Oberseite (der oberen Halbzelle 5 zugekehrten Seite) der unteren Halbzelle 3 angeordnet ist. Auch der Kontakt 35 zur Folie 15 mit den Kontaktpins 17 ist in Fig. 3 dargestellt.

In Fig. 3 ist durch Pfeile 39 die Strömung des Elektrolyts durch den Prüfraum 7 symbolisiert. Elektrolyt tritt durch eine Öffnung 41 in den Prüfraum 7 ein und verlässt diesen durch eine Öffnung 43 wieder.

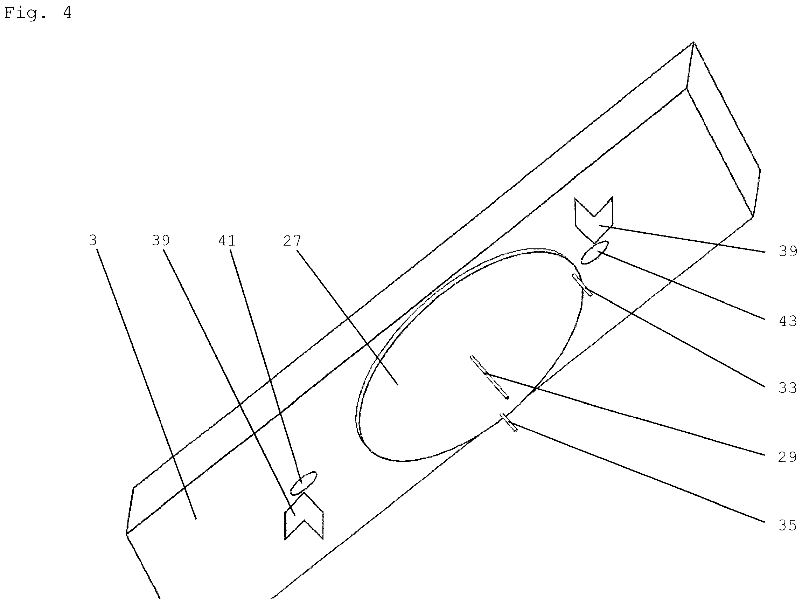

Fig. 4 zeigt die untere Halbzelle 3 von unten gesehen und wie der Anodenkontakt 29 durch den Anodendeckel 27 bis in Anlage an die Anodenplatte 25 geführt ist. Weiters zeigt Fig. 4 auch die Lage des Referenzelektrodenkontaktes 33.

Fig. 4 zeigt weiters die Eintrittsöffnung 41 und die Austrittsöffnung 43 für Elektrolyt, der durch den Hohlraum (=Prüfraum 7), der zwischen der unteren Halbzelle 3 und der oberen Halbzelle 5 gebildet ist, geleitet wird.

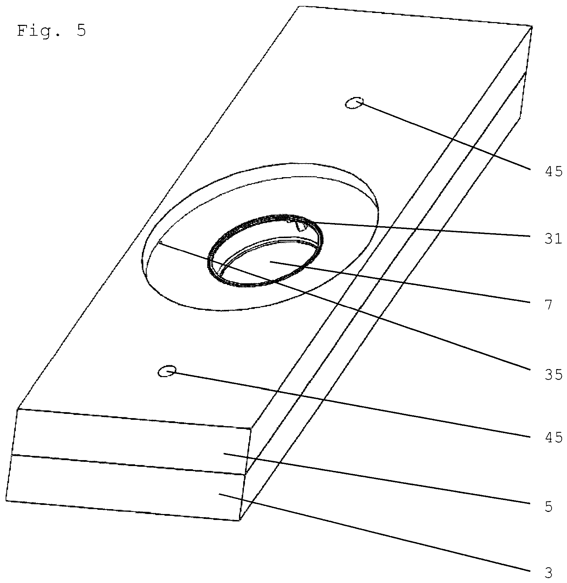

Fig. 5 zeigt die obere Halbzelle 5 und die untere Halbzelle 3 sowie die dazwischen angeordneten Bauteile, jedoch ohne O-Ring 13, Wafer 19 und Folie 15 sowie ohne Zellendeckel 21.

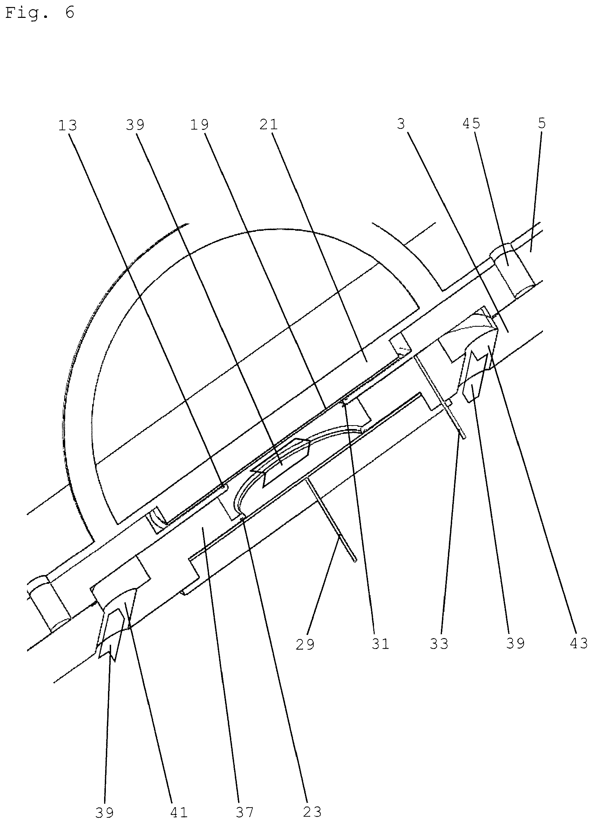

Fig. 6 zeigt eine teilweise Schnittansicht (Schnittebene quer zur Schnittebene von Fig. 2, also in Strömungsrichtung von Elektrolyt durch den Prüfraum 7) von Bauteilen der Vorrichtung 1.

Fig. 6 zeigt wie der Zellendeckel 21 angeordnet ist, um den Wafer 19 dicht zu pressen, wobei durch die stufenförmige Randausbildung zwischen dem Zellendeckel 21 und dem Mittelteil (= Zellenrahmen oder Rahmenteil gebildet von der oberen Halbzelle 5 und der unteren Halbzelle 3) ein vorgegebener Pressdruck gewährleistet ist. Der Zellendeckel 21 kann mit Hilfe von Schrauben, die in Gewindebohrungen 45 in der oberen Halbzelle 5 eingedreht sind, befestigt werden.

Der Zellendeckel der Vorrichtung kann einen normal zur Rückseite des Wafers 19 beweglichen Plug enthalten, der durch Gasdruck an die Rückseite des Wafers 19 angepasst wird. Somit drückt die Wafervorderseite auf die Ringsichtung und der Prüfraum ist damit dicht. Das hat den Vorteil, dass verschieden dicke Wafer 19 eingelegt werde können, z.B. gebondete und damit dickere Wafer 19, und auch den Vorteil, dass die Anpresskraft variiert werden kann (verschieden harte Ringdichtungen).

Eine sinngemäße Anordnung ist an der Unterseite der Vorrichtung 1 vorgesehen, sodass auch hier durch die stufenförmige Randausbildung zwischen dem Mittelteil (Zellenrahmen oder Rahmenteil) und dem in Fig. 6 unten liegenden Anodendeckel 27 die Anodenplatte 25 mit einem vorgegebenen Weg und somit Pressdruck dicht an die Ringdichtung 23 gepresst ist.

Bei der Vorrichtung erfolgt die Abdichtung des Wafers entweder, wie üblich, am Rand des Wafers oder aber auch direkt auf den Mikrochips beziehungsweise generell innerhalb der Waferfläche.

Durch eine Abdichtung direkt auf den Mikrochips bzw. vom Rand des Wafer 19 entfernt wird es möglich, Wafer mit unterschiedlichen Durchmessern und trotzdem konstanter Abmessung des Dichtringes (O-Ringes) mit konstanter Zellgeometrie zu vermessen.

Somit sind die Messsignale, die von unterschiedlichen Wafergrößen erhalten werden, direkt miteinander vergleichbar. Dies ergibt eine größere Flexibilität, weil unterschiedliche Wafergrößen vermessbar sind, was weiters einen geringeren Aufwand bei der Verwaltung der Messdaten ergibt, was übersichtlicher und somit aussagekräftiger ist.

Vorzugsweise wird der Wafer 19 mit zwei oder mehr als zwei Kontaktpins 17 kontaktiert, die an der Folie 15 über den Waferumfang gleichmäßig verteilt angeordnet sind.

Die Dichtkräfte (das Ausmaß der Pressung, der als Ringdichtungen 13 und 23 vorgesehenen O-Ringe) werden durch Anschlag des Zellendeckels 21 und des Anodendeckels 27 an den Zellenrahmen, der von den Halbzellen 3 und 5 gebildet ist, definiert.

Bevorzugt ist es, wenn die Vorrichtung 1 zur Horizontalen um einen spitzen Winkel, z.B. 45°, schräg ausgerichtet wird, und der Wafer 19 so angeordnet wird, dass seine Wafervorderseite nach unten weist und mit dem Elektrolyten, der durch den Prüfraum 7 strömt, in Berührung kommt.

Da eine vertikale Orientierung der Vorrichtung 1 nicht möglich ist (Herausfallen der Ringdichtung 13) und eine waagrechte Ausrichtung der Vorrichtung 1 nachteilig sein kann, da sich Gasblasen, die elektrisch isolierend wirken, sammeln und stauen können, ist die erwähnte schräge Ausrichtung der Vorrichtung 1 von Vorteil.

Für jede Messung der Eigenschaften wird ein (neuer) Testwafer benötigt. Der Testwafer wird im normalen Herstellungsablauf mit üblichen Wafern mit hergestellt, zur Vorrichtung 1 als Messapparatur gegeben, wobei Testwafer mehrfach wiederverwendet werden können (recycliert werden können), sodass dafür keine hohen Kosten anfallen.

Dank der Anordnung der Vorrichtung 1 unter einem spitzen Winkel zur Horizontalen und in einer günstigen Arbeitshöhe, sowie der Lage des Wafers 19 innerhalb der Vorrichtung 1 und der beschriebenen Ausbildung der Ringdichtung 13, kann ein Wafer 19 schnell und sicher (manuell oder automatisch) in die Vorrichtung 1 eingelegt und aus dieser entnommen werden.

Bei der Vorrichtung 1 ist vorgesehen, dass Elektrolyt durch die Öffnung 41 in den Prüfraum 7 der Vorrichtung 1 eintritt, in einer laminaren Strömung durch den Prüfraum 7 strömt und diese durch die Öffnung 43 wieder verlässt und in die Anlageninfrastruktur tritt.

Die Anlageninfrastruktur enthält zumindestens einen Tank für Elektrolyt, vorzugsweise aber mehrere Elektrolyttanks, und eine Pumpe (z.B. Kreiselpumpe) zum gleichmäßigen Umwälzen des Elektrolyts, einen Tank für Reinstwasser oder wenigstens einen Anschluss für Reinstwasser zum Spülen der Vorrichtung 1 mit Wasser, einen Anschluss für Inertgas zum Trocknen der Vorrichtung 1, weiters die erforderlichen Ventile, Leitungen, Regler und Messinstrumente.

Der wenigstens eine im Prüfraum 7 der Vorrichtung 1 vorgesehene Steg 37 stützt die Vorrichtung 1 im Bereich des Prüfraumes 7 und ist für eine laminare Ausbildung der Strömung durch den Prüfraum 7 vorteilhaft.

Der wenigstens eine Steg 37 kann auch die Stelle sein, in der eine chemisch inerte Referenzelektrode 31 in Draht- oder Blechform in den Prüfraum 7 eingeführt ist. Die Referenzelektrode 31 kann alternativ auch durch eine Referenzelektrode zweiter Art laut Stand der Technik ausgebildet sein.

Wenn zum Umwälzen des Elektrolyten eine Kreiselpumpe verwendet wird, kann die Strömungsgeschwindigkeit des Elektrolyten in der Vorrichtung 1 ohne großen Aufwand durch Verändern der Drehgeschwindigkeit des Kreisels eingestellt werden.

Die Anodenplatte 25 wird, wie aus den Zeichnungen ersichtlich, auf ihrer Rückseite kontaktiert. Die Anodenplatte 25, die in der Vorrichtung 1 verwendet wird, ist beidseitig elektrisch leitend und chemisch inert beschichtet. Als Beschichtungsmaterial dient z.B. Platin.

Mit dem erfindungsgemäßen Verfahren können unmittelbare Messungen, also unmittelbar nach einer Produktion, z.B. einer Metallschicht auf einem Wafer 19 ausgeführt werden. Dies erlaubt es, ohne Weiters in der Vorrichtung 1, direkte Messungen (also Überprüfen des originalen Prozessergebnisses, z.B. der originalen Nickelschicht) vorzunehmen.

Diese erfindungsgemäße, nämlich direkte, Methode ist im Vorteil gegenüber indirekten Methoden, wie z.B. dem Charakterisieren des Elektrolyten mit Hilfe anderer Apparaturen und im Rückschluss von der Elektrolytqualität auf die Schichtqualität.

Die Vorrichtung 1 ist so ausgebildet, dass sie ohne großen Aufwand in eine Anlageninfrastruktur aufgenommen werden kann, und dass Umbauarbeiten der Vorrichtung 1 ohne Weiteres vorgenommen werden können.

Eine mögliche Zusatzfunktion der Vorrichtung 1 ist folgende:
Anstatt einer chemisch inerten Anodenplatte 25 kann auch eine Platte aus einem Thermoplast, wie z.B. Polypropylen, mit zwei im rechten Winkel zur Platte eingeschweißten bzw. eingegossenen chemisch inerten Drähten oder Stäben, die zueinander benachbart, aber elektrisch voneinander isoliert sind, verwendet werden. Die Anodenplatte 25 wird in diesem Fall anstelle des Wafers 19 eingesetzt. Einer der beiden Drähte oder Stäbe funktioniert dann als Kathode und einer als Referenzelektrode. Diese Konfiguration von drei chemisch inerten Elektroden kann zum Charakterisieren von Elektrolyten eingesetzt werden.

Zusammenfassend kann ein Ausführungsbeispiel der Erfindung wie folgt beschrieben werden:
Zum Prüfen von Wafern, Mikrochips und dgl. werden elektrische Eigenschaften derselben auf elektrochemischem Weg periodisch gemessen und gespeichert. Die Messwerte werden miteinander verglichen, um Änderungen der elektrischen Eigenschaften zu ermitteln. Für das Ausführen des Verfahrens ist eine als Messzelle ausgebildete Vorrichtung 1 vorgesehen, die zwischen einer oberen Halbzelle 5 und einer unteren Halbzelle 3 einen Prüfraum 7 aufweist, durch den Elektrolyt geleitet wird. Der Prüfraum 7 wird durch einen Zellendeckel 21, der gleichzeitig einen Wafer 19 gegen eine Ringdichtung 13 in Richtung auf die obere Halbzelle 5 drückt, verschlossen. Die den Prüfraum 7 bildende Öffnung in der unteren Halbzelle 3 wird durch eine Ringdichtung 23, eine Anodenplatte 25 und einen Anodendeckel 27 verschlossen.

## Patentansprüche

1. Verfahren zum Prüfen elektrisch leitender Gegenstände, für die laufende Qualitätskontrolle in der Herstellung elektrischer Erzeugnisse wie beispielsweise Wafer oder Mikrochips, mit den Schritten
- periodisches Erfassen von elektrischen Eigenschaften der Gegenstände auf elektrochemischem Weg,
- Speichern von Merkmalen der so erfassten elektrischen Eigenschaften,
- Anwenden statistischer Methoden, um die so erfassten Merkmale elektrischer Eigenschaften verschiedener Gegenstände miteinander zu vergleichen, wobei ein Vergleich von Merkmalen elektrischer Eigenschaften von nacheinander hergestellten Gegenständen ausgeführt wird.
- Ermitteln einer Tendenz von Änderungen der Merkmale der elektrischen Eigenschaften und
- Auswerten der Tendenz, um Änderungen elektrischer Eigenschaften der Gegenstände zu erfassen.

2. Verfahren nach Anspruch 1, **dadurch gekennzeichnet, dass** als elektrische Eigenschaften Strom-Spannungs-Kurven, Strom-Zeit-Kurven, Spannungs-Zeit-Kurven, Impedanzen, Widerstände oder Kapazitäten erfasst werden.

3. Verfahren nach Anspruch 2, **dadurch gekennzeichnet, dass** als Merkmale der Kurven die Steigung des Stromes bei einer definierten Spannung oder der Spannung bei einer definierten Zeit verschiedener Gegenstände miteinander verglichen werden.

4. Verfahren nach einem der Ansprüche 1 bis 3, **dadurch gekennzeichnet, dass** elektrische Eigenschaften von Gegenständen periodisch und in vorgegebenen Zeitabständen erfasst werden.

5. Verfahren nach einem der Ansprüche 1 bis 4, **dadurch gekennzeichnet, dass** ein Vergleich der Merkmale elektrischer Eigenschaften eines Gegenstandes mit den Mittelwerten der Merkmale elektrischer Eigenschaften vorher hergestellter Gegenstände ausgeführt wird.

6. Verfahren nach einem der Ansprüche 1 bis 5, **dadurch gekennzeichnet, dass** die Eigenschaften von elektrisch leitfähigen Schichten, Oberflächen und/oder Grenzflächen (Interfaces) von Gegenständen erfasst werden.

## Claims

1. Method for testing electrically conductive articles, such as wafers or microchips for example, comprising the steps
- periodically detecting electrical properties of the articles by an electrochemical route,
- storing features of the electrical properties thus detected,
- using statistical methods to compare the detected features of electrical properties of different articles with one another, a comparison being carried out on features of electrical properties of successively produced articles,
- ascertaining a trend in changes of the features of the electrical properties, and
- evaluating the trend in order to detect changes in electrical properties of the articles.

2. Method according to claim 1, **characterized in that** current/voltage curves, current/time curves, voltage/time curves, impedances, resistances or capacitances are detected as electrical properties.

3. Method according to claim 2, **characterized in that** the increase in current at a defined voltage or in voltage over a defined time for different articles are compared with one another as features of the curves.

4. Method according to one of claims 1 to 3, **characterized in that** electrical properties of articles are detected periodically and at predefined time intervals.

5. Method according to one of claims 1 to 4, **characterized in that** the features of electrical properties of an article are compared with the mean values of the features of electrical properties of previously produced articles.

6. Method according to one of claims 1 to 5, **characterized in that** the properties of electrically conductive layers, surfaces and/or interfaces of articles are detected.

## Revendications

1. Procédé de contrôle d'objets électriquement conducteurs, pour un contrôle continu de la qualité dans la fabrication de produits électriques tels que des plaquettes ou des micropuces, comprenant les étapes consistant à :
- détecter périodiquement des propriétés électriques des objets par voie électrochimique,
- stocker des caractéristiques des propriétés électriques ainsi détectées,
- appliquer des méthodes statistiques pour comparer les caractéristiques des propriétés électriques de différents objets ainsi détectées, une comparaison des caractéristiques des propriétés électriques d'objets fabriqués successivement étant réalisée,
- déterminer une tendance dans les changements des caractéristiques des propriétés électriques et
- évaluer la tendance pour détecter des changements dans les propriétés électriques des objets.

2. Procédé selon la revendication 1, **caractérisé en ce que** des courbes courant-tension, des courbes courant-temps, des courbes tension-temps, des impédances, des résistances ou des capacités sont détectées en tant que propriétés électriques.

3. Procédé selon la revendication 2, **caractérisé en ce que** la pente du courant à une tension définie ou de la tension à un temps défini de différents objets sont comparées entre elles en tant que caractéristiques des courbes.

4. Procédé selon l'une des revendications 1 à 3, **caractérisé en ce que** des propriétés électriques d'objets sont détectées périodiquement et à des intervalles de temps prédéfinis.

5. Procédé selon l'une des revendications 1 à 4, **caractérisé en ce qu'**une comparaison des caractéristiques des propriétés électriques d'un objet avec les valeurs moyennes des caractéristiques de propriétés électriques d'objets fabriqués précédemment est réalisée.

6. Procédé selon l'une des revendications 1 à 5, **caractérisé en ce que** les propriétés de couches, surfaces et/ou surfaces limites (interfaces) électriquement conductrices d'objets sont détectées.
